# EUROPEAN PATENT SPECIFICATION

(11) **EP 2 075 162 B1**
(45) Date of publication and mention of the grant of the patent: **19.09.2018**
(21) Application number: 07806149.6
(22) Date of filing: 28.08.2007
(51) Int. Cl.: H05K 5/00

(54) **CIRCUIT UNIT HOUSING BOX**
SCHALTUNGSEINHEITAUFNAHMEKASTEN
BOITE DE RECEPTION D'UNITE DE CIRCUIT

(30) Priority: 20.09.2006 JP 2006254203
(43) Date of publication of application: 01.07.2009
(73) Proprietor: Tyco Electronics Japan G.K., Takatsu-ku Kawasaki Kanagawa 213-8535 (JP); Daiwa Kasei Industry Co., Ltd., Okazaki-shi, Aichi 444-0004 (JP); TOYOTA JIDOSHA KABUSHIKI KAISHA, Toyota-shi, Aichi-ken, 471-8571 (JP); Tyco Electronics Japan G.K., Takatsu-ku Kawasaki-shi Kanagawa 213-8535 (JP)
(72) Inventor: NAGAI, Ryuichi, Kawasaki-shi, Kanagawa 213-8535 (JP); SUGIYAMA, Takahiro, Okazaki, Aichi 444-0004 (JP); YAMANOUCHI, Yuchi, Toyota-shi, Aichi-ken 471-8571 (JP)
(74) Representative: Schmitt-Nilson Schraud Waibel Wohlfrom Patentanwälte Partnerschaft mbB
(86) International application number: PCT/JP2007/066671
(87) International publication number: WO 2008/035548

(56) References cited:
- EP-A2- 0 823 834
- EP-A2- 0 896 397
- JP-A- 11 054 210
- JP-A- 2001 148 267
- JP-A- 2003 324 824
- JP-A- 2006 137 234
- US-A- 5 788 522
- US-A1- 2005 112 940

## Description

### TECHNICAL FIELD

The present invention relates to a circuit unit accommodation box into which a circuit unit such as an ECU comprising an electrical connector is inserted.

### BACKGROUND ART

In recent years, there has been an increased demand in the automotive field for accommodating and attaching, in a centralized and comprehensive manner, a plurality of circuit units such as ECUs comprising electrical connectors (first connectors) in a circuit unit accommodation box that is mounted in advance on the side of a vehicle.

According to US 5 788 522 a movable connector is adapted to be mounted on an attachment member and a mounting member to which the attachment member is fixed, and this movable connector includes one connector for being fixedly mounted on the attachment member, a holder for being fixedly mounted on the mounting member, and the other connector movably mounted on the holder. The other connector is provisionally retained relative to the holder before the attachment member and the mounting member are completely fixed together, and the other connector is fitted relative to the one connector when the attachment member approaches the mounting member, and then this provisional retaining condition is released, and the other connector is movable within the holder by an amount corresponding to an amount of movement of the attachment member required for complete fixing to the mounting member.

According to US 2005/112940 A1 each of a plurality of electronic control units is configured to control electronic components in a vehicle, and is provided with a plurality of first terminals classified into a plurality of groups each of which is associated with electronic components in one of sections in the vehicle. A board has a first face on which the electronic control units are mounted. First connectors are provided on a second face of the board. Each of the first connectors has second terminals each of which is electrically connected to one of the first terminals in one of the groups in each of the electronic control units, and is configured to be connected to a wire harness extended to one of the sections in the vehicle.

According to EP 0 896 397 A2 one of female and male connectors is installed on a mounting base in a waiting condition in which it projects through a holder, and can be freely coupled with the other connector in a projecting waiting direction of the one connector. The one connector is provided freely slidably in the holder and after the other connector is coupled with the one connector, both the connectors are freely slidable relative to the holder in a coupling completion condition toward the mounting base. A clearance is provided between the holder and the one connector. A hood of the one connector is provided slidably in the holder. A flexible arm has an engaging portion at an end thereof. The one connector is constituted with a flexible engaging piece having an engaging portion to be fit to/released from the engaging portion of the flexible arm; and the flexible engaging piece is freely contactable with a side wall in the vicinity of the flexible arm of the holder.

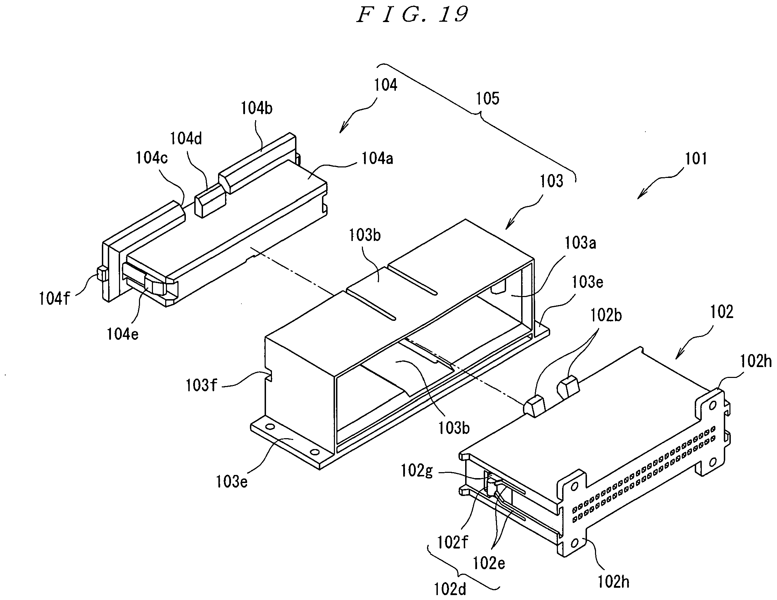

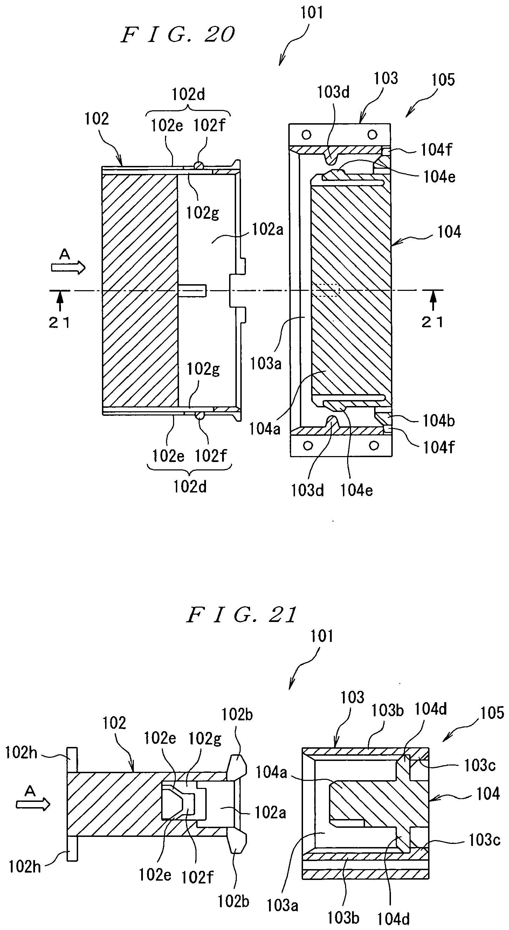

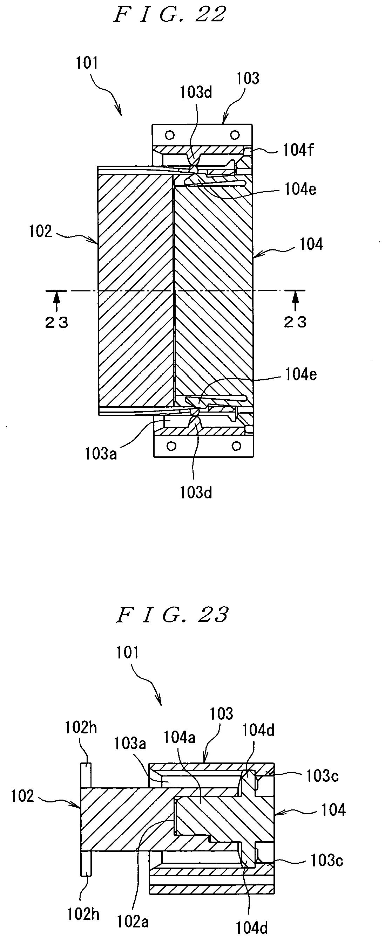

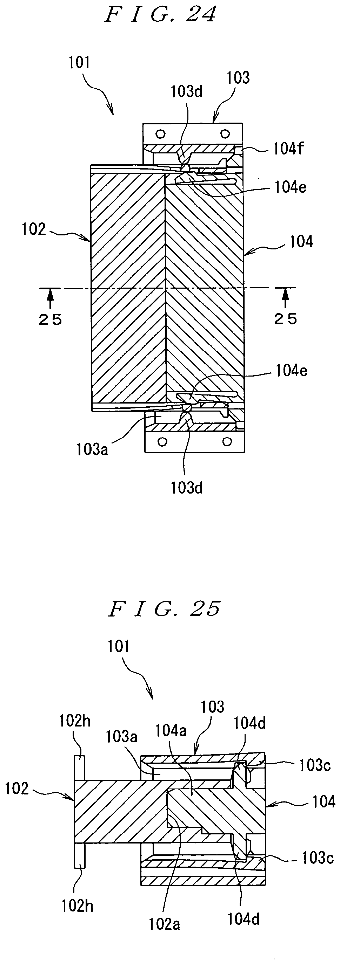

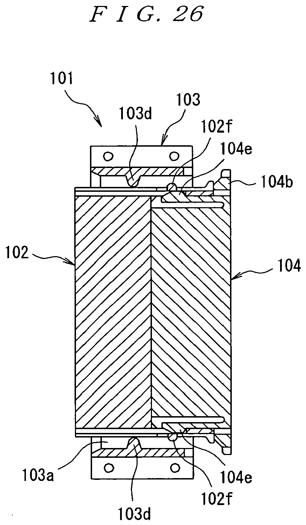

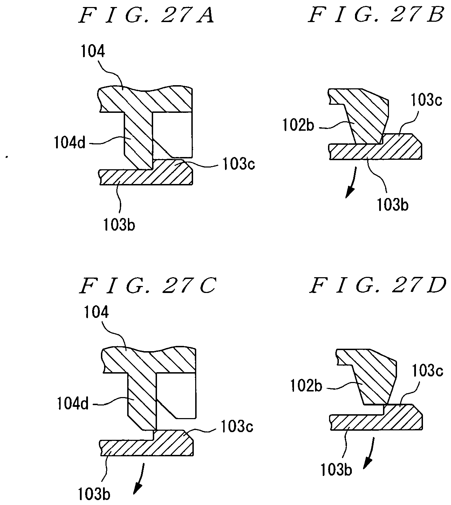

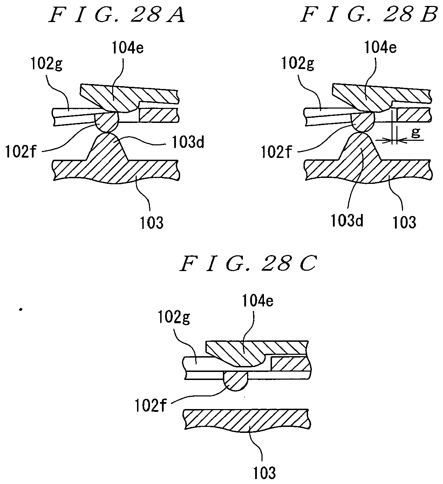

The connector device shown in FIGS. 19 through 28C (see JP2002-246106 A), for example, has been known as a connector device combining a first structural body such as a circuit unit comprising a fist connector and a second structural body having a receptacle electrical connector that connects with the first connector. FIG. 19 is a perspective view of the assembly of a conventional example of a connector device having a receptacle electrical connector. FIG. 20 is a sectional view showing a state in which the second connector is accommodated in the receptacle part in the connector device shown in FIG. 19, shown together with the first connector. FIG. 21 is a sectional view along line 21-21 in FIG. 20. FIG. 22 is an explanatory diagram of the connector device shown in FIG. 21 at an intermediate point during mating. FIG. 23 is a sectional view along line 23-23 in FIG. 22. FIG. 24 is an explanatory diagram of the connector device shown in FIG. 22 at an intermediate point during mating. FIG. 25 is a sectional view along line 25-25 in FIG. 24. FIG. 26 is an explanatory diagram of the completed state of mating of the connector device shown in FIG. 24. FIGS. 27A through 27D are the explanatory diagrams showing the relationship between locking means and unlocking means in the assembly consisting of the first connector, receptacle part, and second connector. FIGS. 28A through 28C are the explanatory diagrams showing the relationship between locking means for locking the first connector and second connector and unlocking means.

The connector device 101 shown in FIG. 19 is designed to combine a first structural body (not shown in the figures) such as a circuit unit comprising a first connector 102 and a second structural body (not shown in the figures) having a receptacle electrical connector 105 that connects with the first connector 102.

Here, the first connector 102 is formed in a substantially rectangular flattened shape, and has an opening 102a that receives the mating part 104a of the second connector 104 at the front end (right end in FIG. 20) as shown in FIG. 20. Pairs of unlocking keys (unlocking means) 102b are respectively provided on two surfaces of the first connector 102 (one pair on
the upper surface and the other pair on the lower surface) at the front ends thereof. Furthermore, as is shown in FIGS. 19 and 20, a pair of unlocking ribs (unlocking means) 102d are provided with one rib being provided on either side surface of the first connector 102. Each unlocking rib 102d is constructed from a pair of upper and lower ribs 102e that extend from the rear end side toward the center and a projection 102f that links the front end portions of these ribs 102e and that protrudes outward in a semi-circular shape. Moreover, engaging windows 102g that open into the opening 102a are formed in both side surfaces of the first connector 102 corresponding to the projections 102f of the unlocking ribs 102d. In addition, attachment parts 102h for the first structural body are provided at four corners of the rear end portion of the first connector 102.

Furthermore, the receptacle electrical connector 105 comprises a receptacle part 103 that is fastened to a second structural body (not shown in the figures) and a second connector 104 that is accommodated in the receptacle part 103 and that makes mating connection with the first connector 102 when the first structural body and second structural body are assembled together.

Here, as is shown in FIGS. 19 and 20, the second connector 104 comprises a substantially rectangular mating part 104a that is received in the opening 102a of the first connector 102 and a flange part 104b that is provided on the rear portion (right portion in FIG. 20) of the mating part 104a. The second connector 104 is designed to be attached inside a through-hole 103a of the receptacle part 103 from the rear. Cutouts 104c each allowing the passage of two unlocking keys 102b are respectively formed in the upper and lower central portions of the flange part 104b. Moreover, locking parts 104d respectively protrude from both upper and lower surfaces of the second connector 104 in the vicinity of the cutouts 104c. Each locking part 104d can pass between two unlocking keys 102b. Moreover, locking members (locking means) 104e that respectively engage with the engaging windows 102g in the first connector 102 and thus lock the first connector 102 and second connector 104 are provided on both side surfaces of the mating part 104a of the second connector 104. A pair of projections 104f is provided with one projection protruding from either side surface of the flange part 104b of the second connector 104.

In addition, as is shown in FIGS. 19 and 20, the receptacle part 103 is formed in a substantially rectangular shape, and is provided with a through-hole 103a that passes through in the front-back direction (left-right direction in FIG. 20) and that accommodates the second connector 104 on the inside. A pair of mutually facing locking spring ribs (locking means) 103b are provided in the center of either surface (upper and lower surfaces) of the receptacle part 103. As is shown in FIG. 21, locking claws 103c protrude inward from the rear ends of the respective locking spring ribs 103b. Furthermore, as is shown in FIG. 20, projections 103d used as unlocking means are provided on the respective inner surfaces of both side walls of the receptacle part 103. Moreover, attachment parts 103e for the second structural body are provided on the lower end portions of both side walls of the receptacle part 103. In addition, a pair of cutouts 103f with which the projections 104f of the second connector 104 are locked are formed in the rear surface of either side wall of the receptacle part 103.

Next, the actions of the respective constituent elements in the connector device 101 will be described.

As is shown in FIGS. 20 and 21, when the second connector 104 is inserted into the through-hole 103a from the rear end of the receptacle part 103, the locking parts 104d of the second connector 104 respectively push the locking spring ribs 103b of the receptacle part 103 outward, so that the tip ends of the locking parts 104d are locked in by the locking claws 103c, and the projections 104f of the second connector 104 are locked with the cutouts 103f in the receptacle part 103. As a result, the second connector 104 is accommodated and held inside the through-hole 103a in the receptacle part 103, thus completing a receptacle electrical connector 105.

Furthermore, when the first structural body comprising the first connector 102 is moved in the direction of arrow A shown in FIGS. 20 and 21, the front end of the first connector 102 is inserted into the through-hole 103a in the receptacle part 103 of the receptacle electrical connector 105. Meanwhile, the locking members 104e of the second connector 104 are inserted into the opening 102a in the first connector 102, the first connector 102 slides inside the through-hole 103a, and the mating of the two connectors 102 and 104 is initiated. Then, the first connector 102 further slides inside the through-hole 103a, so that the first connector 102 and second connector 104 are placed in the state at an intermediate point during mating shown in FIGS. 22 and 23. In this state, as is shown in FIG. 27B, the unlocking keys 102b of the first connector 102 have just made contact with the locking claws 103c of the receptacle part 103, so that the locking parts 104d of the second connector 104 are left locked in by the locking claws 103c of the receptacle part 103 as shown in FIG. 27A, and the second connector 104 is left accommodated and held inside the through-hole 103a in the receptacle part 103. In this state, furthermore, the projections 102fof the unlocking ribs 102d of the first connector 102 are pressed inward by the projections 103d of the receptacle part 103 as shown in FIG. 28A; as a result, the locking members 104e of the second connector 104 are displaced inward, so that these locking members 104e are not completely engaged with the engaging windows 102g. Accordingly, the first connector 102 and second connector 104 are not locked together.

When the first structural body comprising the first connector 102 moves further from this state by the gap g in FIG. 28B in the direction of arrow A shown in FIGS. 20 and 21, the first connector 102 and second connector 104 are placed in the state immediately prior to the mating completion shown in FIGS. 24 and 25. In this state, as is shown in FIG. 27D, the unlocking keys 102b of the first connector 102 respectively push the locking spring ribs 103b of the receptacle part 103 outward, so that the locking parts 104d of the second connector 104 is unlocked from the locking claws 103c of the receptacle part 103 as shown in FIG. 27C. In this state, furthermore, the projections 102f of the unlocking ribs 102d of the first connector 102 are left pressed inward by the projections 103d of the receptacle part 103 as shown in FIG. 28B. As a result, the locking members 104e of the second connector 104 are displaced inward, so that these locking members 104e are not completely engaged with the engaging windows 102g. Consequently, the first connector 102 and second connector 104 are not locked together.

Then, when the first structural body comprising the first connector 102 is moved further in the direction of arrow A shown in FIGS. 20 and 21, the pressed state of the projections 102f of the unlocking ribs 102d by the projections 103d of the receptacle part 103 is released as shown in FIG. 28C, so that the locking members 104e of the second connector 104 are completely engaged with the engaging windows 102g, and the first connector 102 and second connector 104 are locked together, thus completing the mating of the two connectors 102 and 104. Moreover, the front end of the first connector 102 presses the flange part 104b of the second connector 104, so that the state shown in FIG. 26 is created. In this state shown in FIG. 26, because the second connector 104 is away from the inner wall surfaces of the receptacle part 103, it is possible to completely prevent the transmission of vibration on the side of the second structural body attached to the receptacle part 103 to the second connector 104, thus preventing the generation of vibration stress or noise caused by the vibration.

### [Problems to Be Solved by the Invention]

However, the following problems have been encountered in this conventional connector device 101:
Specifically, with regard to the connector device 101, there is no specific disclosure as to how the first structural body comprising the first connector 102 is combined with, held by, and attached to the second structural body having the receptacle electrical connector 105, or as to the timing with which the first structural body is combined, held, and attached, so that the joint structure of the first structural body and second structural body cannot be understood at all. For this reason, the connector device 101 cannot be applied to a construction in which a circuit unit comprising the first connector is accommodated in a circuit unit accommodation box having a receptacle electrical connector, which has been a demand in recent years in the automotive field.

Furthermore, in the accommodation of a circuit unit into a circuit unit accommodation box, it is desirable that the worker be able to attach the circuit unit to the circuit unit accommodation box with a simple operation and also to perceive easily by sensation the completion of the attachment of the circuit unit to the circuit unit accommodation box.

### DISCLOSURE OF THE INVENTION

Accordingly, it is an object of the present invention to provide a circuit unit accommodation box having a receptacle electrical connector, wherein the circuit unit accommodation box can reliably accommodate a circuit unit comprising a first connector, and in the accommodation of the circuit unit into the circuit unit accommodation box, the worker can attach the circuit unit to the circuit unit accommodation box with a simple operation, and can also perceive easily by sensation the completion of the attachment of the circuit unit to the circuit unit accommodation box.

### [Means Used to Solve the Problems]

In order to solve the problems described above, the circuit unit accommodation box of Claim 1 is a circuit unit accommodation box comprising a box body having at least one circuit unit accommodating part into which a circuit unit equipped with a first connector is inserted, and a receptacle electrical connector that is disposed in the circuit unit accommodating part and that makes an electrical connection with the inserted circuit unit, wherein the receptacle electrical connector comprises a cover part that receives the circuit unit and guides the circuit unit to a specified position, a second connector that is accommodated inside the cover part and locked with the cover part by locking means and that mates with the first connector and establishes electrical connection with the first connector when the received circuit unit is inserted into a first position, and unlocking means for unlocking the second connector from the locking means when the circuit unit is inserted from the first position into a position further toward the interior, with the second connector becoming slidable inside the cover part in the direction of insertion and withdrawal of the circuit unit after the second connector is unlocked by the unlocking means, and the box body and the circuit unit comprise holding means for holding the circuit unit in the box body when the circuit unit is inserted from the first position to a second position via the interior position.

Furthermore, the circuit unit accommodation box of Claim 2 is the circuit unit accommodation box according to Claim 1, wherein the box body is provided with a window part that allows the viewing of the state of the circuit unit being held by the holding means.

Moreover, the circuit unit accommodation box of Claim 3 is the invention according to Claim 1 or 2, wherein the box body comprises an attachment part for a vehicle body, and the second connector is attached inside the cover part from the direction opposite to the circuit unit insertion direction.

### [Effect of the Invention]

The circuit unit accommodation box of Claim 1 is the circuit unit accommodation box comprising the box body having at least one circuit unit accommodating part into which the circuit unit equipped with the first connector is inserted, and the receptacle electrical connector that is disposed in the circuit unit accommodating part and that makes the electrical connection with the inserted circuit unit, wherein the receptacle electrical connector comprises the cover part that receives the circuit unit and guides this circuit unit to the specified position, the second connector that is accommodated inside the cover part and locked with the cover part by locking means and that mates with the first connector and establishes electrical connection with this first connector when the received circuit unit is inserted into the first position, and unlocking means for unlocking the second connector from the locking means when the circuit unit is inserted from the first position into the position further toward the interior, with the second connector becoming slidable inside the cover part in the direction of insertion and withdrawal of the circuit unit after the second connector is unlocked by the unlocking means, and the box body and the circuit unit comprise holding means for holding the circuit unit in the box body when the circuit unit is inserted from the first position to the second position via the interior position. Accordingly, when the circuit unit comprising the first connector is inserted into the circuit unit accommodating part of the box body to the first position, the first connector mates with the second connector of the receptacle electrical connector, so that the first connector and second connector are electrically connected. Then, when the circuit unit is inserted into the second position, the circuit unit is held in the box body by the holding means. Accordingly, it is possible to provide a circuit unit accommodation box which can reliably accommodate the circuit unit comprising the first connector. Furthermore, merely by inserting the circuit unit into the box body, this circuit unit can be attached to the circuit unit accommodation box, so that the circuit unit can be attached to the circuit unit accommodation box with a simple operation. Moreover, the first position in which the first connector and second connector mate with each other is different from the second position in which the circuit unit is held in the box body, and the peak of the force required for the mating of the connectors and the peak of the force required for the locking for the purpose of holding the circuit unit in the box body are separated from each other. Therefore, the worker can easily perceive by sensation that the attachment of the circuit unit to the circuit unit accommodation box is completed.

Furthermore, in the circuit unit accommodation box of Claim 2, the box body is provided with a window part that allows the viewing of the state of the circuit unit being held by the holding means in the circuit unit accommodation box according to Claim 1. Therefore, it is possible to view from the window part the state in which the circuit unit is held in the second position, thus making it possible to confirm that the circuit unit is firmly mounted to the circuit unit accommodation box.

In addition, in the circuit unit accommodation box of Claim 3, the box body comprises an attachment part for a vehicle body in the invention according to Claim 1 or 2. Therefore, the circuit unit accommodation box can be attached to a vehicle body. Furthermore, because the second connector is attached inside the cover part from the direction opposite to the circuit unit insertion direction, the second connector at the wire harness end can be combined to the box body before the circuit unit is mounted to the circuit unit accommodation box when the circuit unit accommodation box is to be attached to the vehicle body. As a result, man-hours in the assembly work of the circuit unit can be reduced, and half-mating of the first connector with the second connector can be prevented.

### BRIEF DESCRIPTION OF THE DRAWINGS

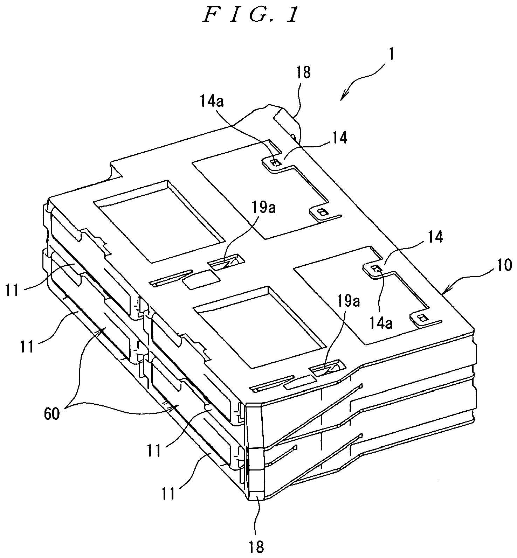

FIG. 1 is a perspective view showing a state in which circuit units are accommodated in a circuit unit accommodation box of the present invention;

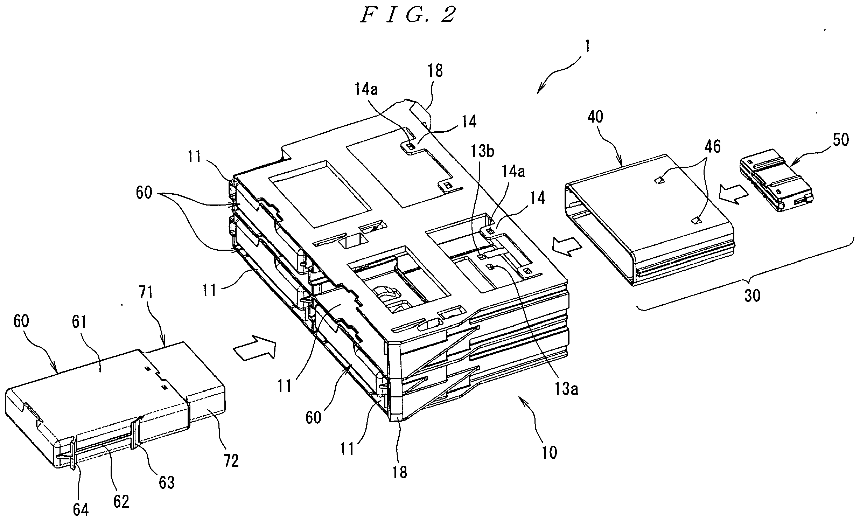

FIG. 2 is a perspective view showing a circuit unit accommodation box, with the box body, one of the receptacle connectors, and one of the circuit units that make up the circuit unit accommodation box being disassembled;

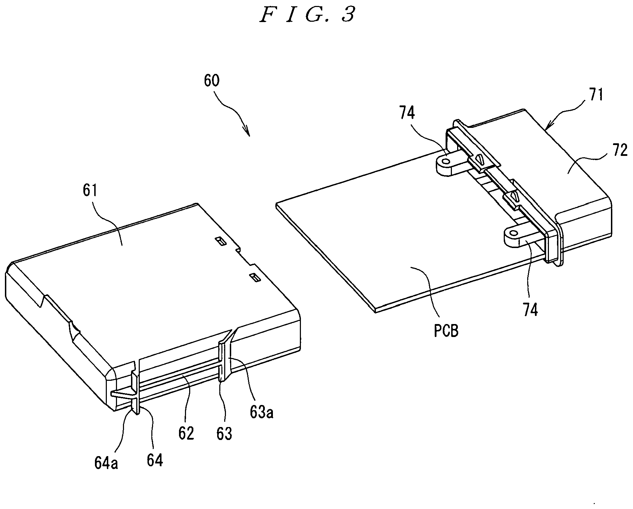

FIG. 3 is an exploded perspective view of a circuit unit;

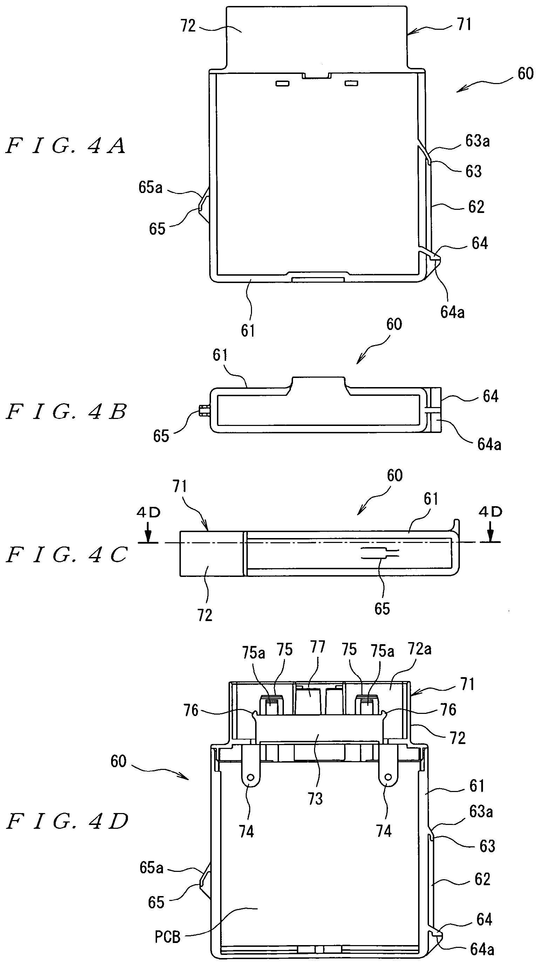

FIGS. 4A through 4D show the circuit unit of FIG 3, with FIG. 4A being a plan view, FIG. 4B being a front view, FIG. 4C being a left side view, and FIG. 4D being a sectional view along line 4D-4D in FIG. 4C;

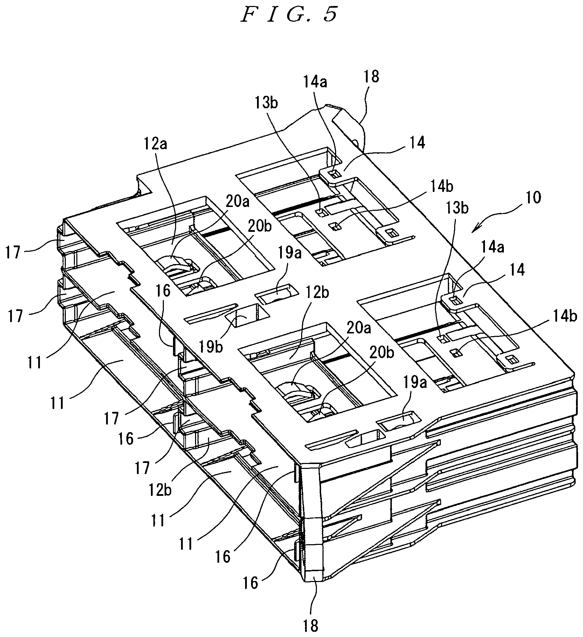

FIG. 5 is a perspective view of the box body as seen from the front side;

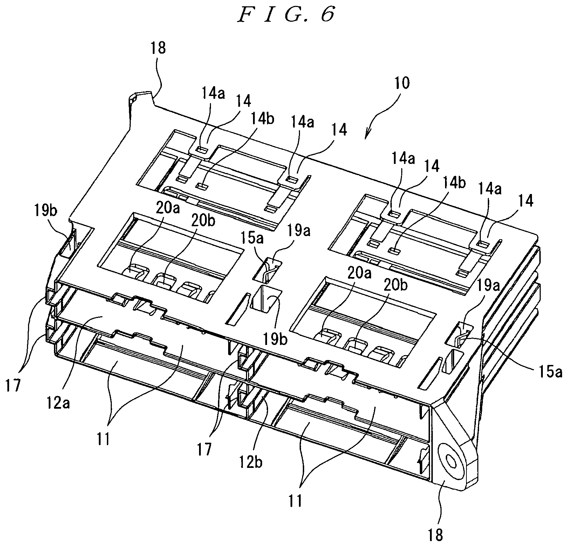

FIG. 6 is a perspective view of the box body as seen with the viewing angle slightly varied from FIG. 5;

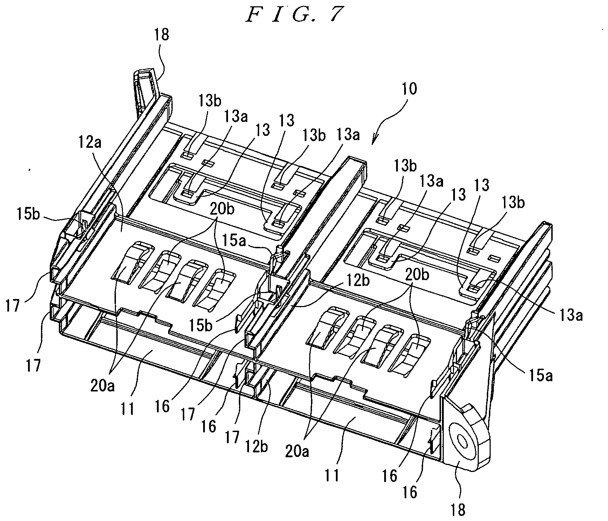

FIG. 7 is a perspective view showing a state in which the upper wall is removed from the box body shown in FIG. 6;

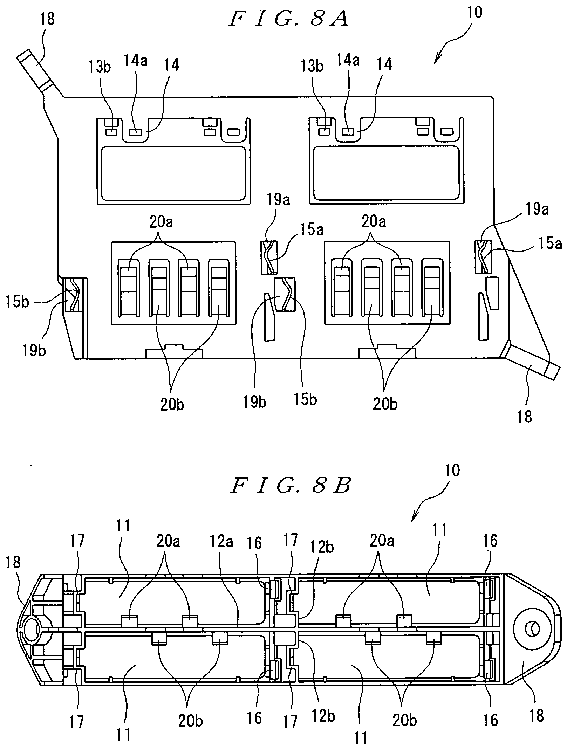

FIGS. 8A and 8B show the box body, with FIG. 8A being a plan view, and FIG. 8B being a front view;

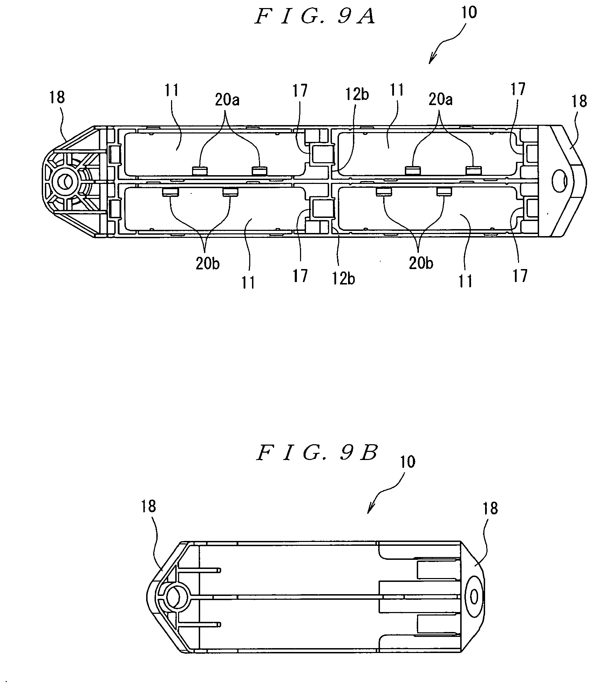

FIGS. 9A and 9B show the box body, with FIG. 9A being a back view, and FIG. 9B being a left side view;

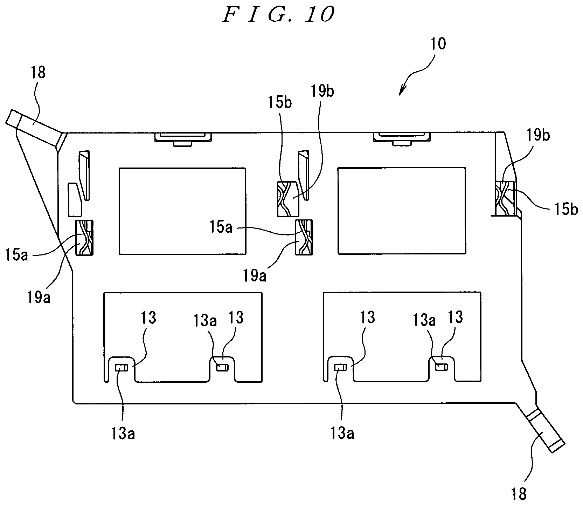

FIG. 10 is a bottom view of the box body;

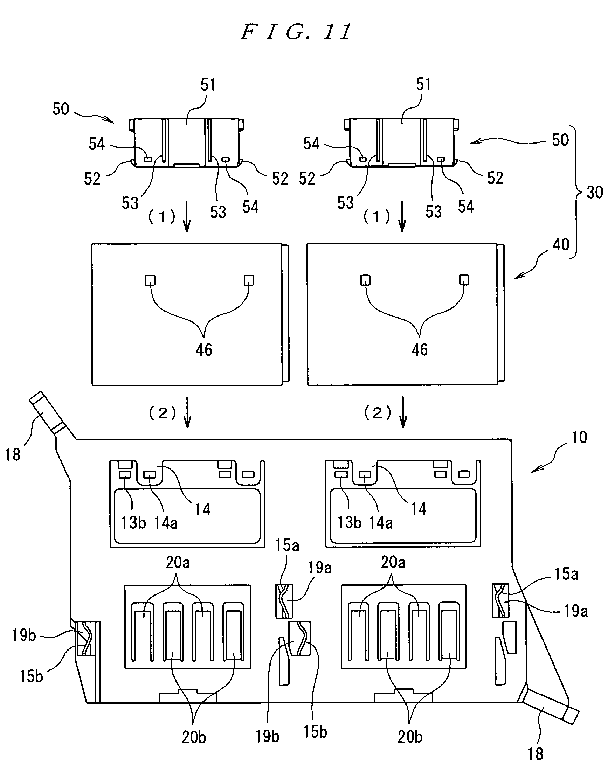

FIG. 11 is a plan view for illustrating the procedure for attaching receptacle electrical connectors to the box body;

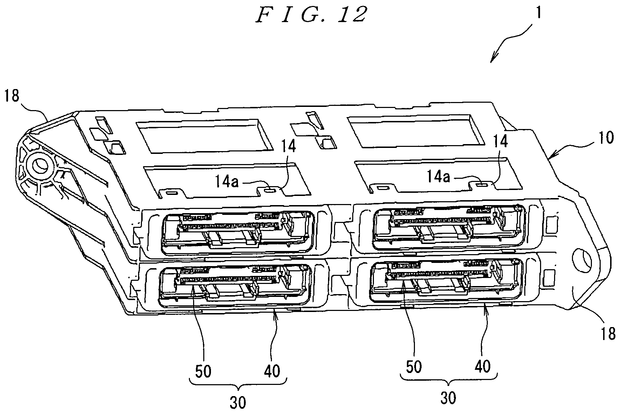

FIG. 12 is a perspective view as seen from the back side of the circuit unit accommodation box in which the receptacle electrical connectors have been attached to the box body;

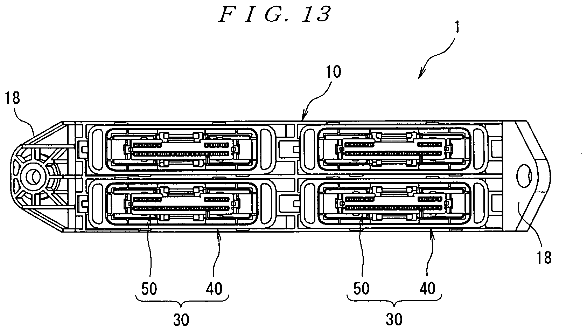

FIG. 13 is a back view of the circuit unit accommodation box in which the receptacle electrical connectors have been attached to the box body;

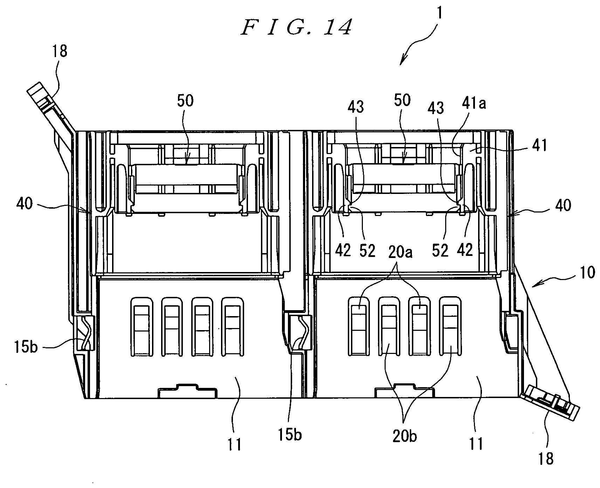

FIG. 14 is a sectional view of the circuit unit accommodation box in which the receptacle electrical connectors have been attached to the box body;

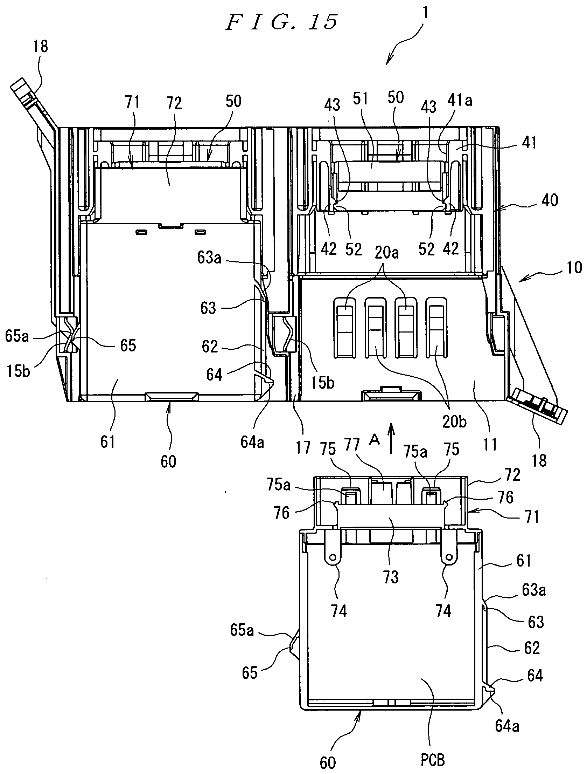

FIG. 15 is a sectional view showing a state prior to the insertion of the circuit units into the circuit unit accommodation box; in this FIG. 15, however, a circuit unit has been inserted into the left-side circuit unit accommodating part out of the upper circuit unit accommodating parts;

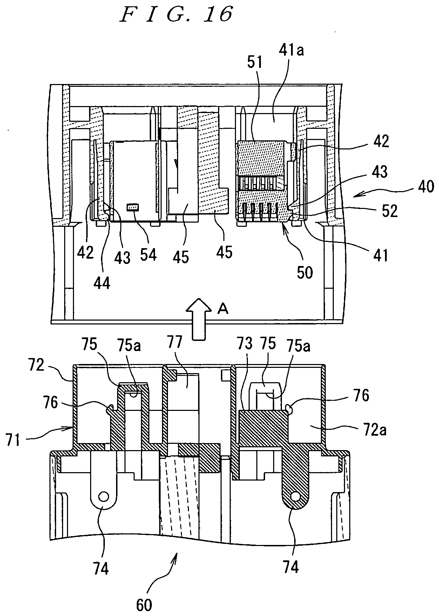

FIG. 16 is a sectional view of essential parts showing a state prior to the insertion of the circuit units into the circuit unit accommodation box, with the position of the cross section being varied from FIG. 15;

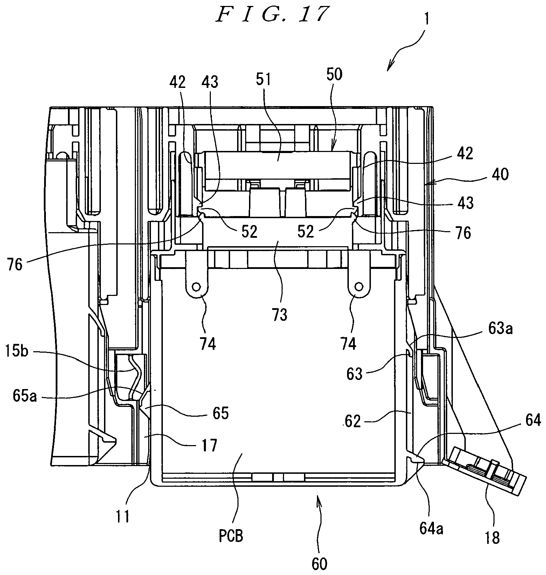

FIG. 17 is a sectional view showing a state in which a circuit unit has been inserted into the first position, and the first connector of the circuit unit has mated with the corresponding second connector;

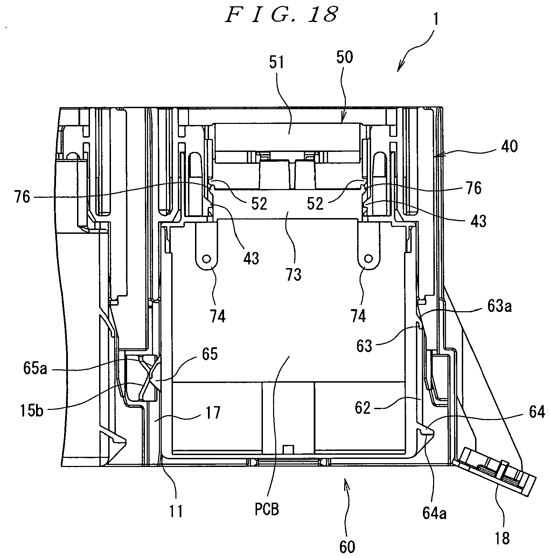

FIG. 18 is a sectional view showing a state in which the circuit unit has been inserted into the second position, and the accommodation of the circuit unit in the circuit unit accommodation box has been completed;
FIG. 19 is a perspective view of the assembly of a conventional example of a connector device having a receptacle electrical connector;
FIG. 20 is a sectional view showing a state in which the second connector is accommodated in the receptacle part in the connector device shown in FIG. 19, shown together with the first connector;
FIG. 21 is a sectional view along line 21-21 in FIG. 20;
FIG. 22 is an explanatory diagram of the connector device shown in FIG. 21 at an intermediate point during mating;
FIG. 23 is a sectional view along line 23-23 in FIG. 22;
FIG. 24 is an explanatory diagram of the connector device shown in FIG. 22 at an intermediate point during mating;
FIG. 25 is a sectional view along line 25-25 in FIG. 24;
FIG. 26 is an explanatory diagram of the completed state of mating of the connector device shown in FIG. 24;
FIGS. 27A through 27D are the explanatory diagrams showing the relationship between locking means and unlocking means in the assembly consisting of the first connector, receptacle part, and second connector; and
FIGS. 28A through 28C are the explanatory diagrams showing the relationship between locking means for locking the first connector and second connector and unlocking means.

### [Explanation of Symbols]

- 1:: Circuit unit accommodation box
- 10:: Box body
- 11:: Circuit unit accommodating part
- 15a:: First spring part (holding means)
- 15b:: Second spring part (holding means)
- 16:: Locking part (holding means)
- 18:: Attachment part for vehicle body
- 19a:: First window part (window part)
- 19b:: Second window part (window part)
- 30:: Receptacle electrical connector
- 40:: Cover part
- 43:: First projection (locking means)
- 44:: Second unlocking projection (unlocking means)
- 50:: Second connector
- 60:: Circuit unit
- 63:: First rib (holding means)
- 64:: Second rib (holding means)
- 65:: Third rib (holding means)
- 71:: First connector

### BEST MODE FOR CARRYING OUT THE INVENTION

Next, an embodiment of the present invention will be described with reference to the figures. FIG. 1 is a perspective view showing a state in which circuit units are accommodated in a circuit unit accommodation box of the present invention. FIG. 2 is a perspective view showing a circuit unit accommodation box, with the box body, one of the receptacle connectors, and one of the circuit units that make up this circuit unit accommodation box being disassembled.

In FIGS. 1 and 2, the circuit unit accommodation box 1 is constructed so as to accommodate a plurality of circuit units 60 (four circuit units in the present embodiment), and comprises a box body 10 and receptacle electrical connectors 30.

FIG. 3 is an exploded perspective view of a circuit unit. FIGS. 4A through 4D show the circuit unit of FIG 3; FIG. 4A is a plan view, FIG. 4B is a front view, FIG. 4C is a left side view, and FIG. 4D is a sectional view along line 4D-4D in FIG. 4C.

As is shown in FIGS. 2 through 4D, each circuit unit 60 comprises a substantially flattened square cylindrical housing 61 and a first connector 71 fastened to the front end (right end in FIG. 2) of this housing 61. The first connector 71 has a substantially flattened square cylindrical housing 72 fastened to the front end of the housing 61. As is shown in FIG. 4D, a recessed part 72a that opens to the front surface and that receives the connector accommodating part 41 of a receptacle electrical connector 30 is formed in the interior of the housing 72. Furthermore, as is shown in FIG. 4D, a substantially rectangular contact fastening part 73 that extends in the direction of width of the housing 72 is provided inside this recessed part 72a so as to protrude forward from the bottom of the recessed part 72a. A plurality of rows of contacts (not shown in the figures) is attached to this contact fastening part 73. Moreover, a pair of fastening parts 74 for fastening the housing 72 to the surface of a circuit board PCB is provided on the rear portion of the housing 72. The respective contacts mentioned above are configured such that the rear end portions thereof are connected by soldering to the circuit board PCB. In addition, pairs of locking parts 75 are respectively provided on two surfaces of the contact fastening part 73 (one pair on the upper surface and the other pair on the lower surface) such that these locking parts 75 protrude forward from the contact fastening part 73. An opening 75a is formed in each of these locking parts 75. Furthermore, pairs of first unlocking projections 76 are respectively provided on either side surface in the direction of width of the contact fastening part 73 at two ends thereof (one pair at the upper end and the other pair at the lower end). Moreover, an erroneous mating prevention plate 77 extends forward from substantially the central portion in the direction of width of the front surface of the contact fastening part 73 slightly toward the upper side in the vertical direction.

In addition, a projecting rib 62 that extends in the front-back direction is formed on the right side surface (right side surface in FIG. 4A) of the housing 61 of each circuit unit 60, and a first rib part 63 is provided at the front end of this projecting rib 62, while a second rib 64 is provided at the rear end of the projecting rib 62. The first rib part 63 extends in the vertical direction (vertical direction in FIG. 4C) of the housing 61, and an inclined surface 63a is formed on the front side thereof. Furthermore, the second rib 64 extends in the vertical direction of the housing 61, and a perpendicular surface 64a is formed on the rear side. Meanwhile, a third rib 65 is formed on the left side surface of the housing 61 substantially in the central portion in the vertical direction. The third rib 65 is provided in a position that is substantially intermediate between the first rib 63 and second rib 64 in the front-back direction. The front side of the third rib 65 is formed with an inclined surface 65a.

FIG. 5 is a perspective view of the box body as seen from the front side. FIG. 6 is a perspective view of the box body as seen with the viewing angle slightly varied from FIG. 5. FIG. 7 is a perspective view showing a state in which the upper wall is removed from the box body shown in FIG. 6. FIGS. 8A and 8B show the box body; FIG. 8A is a plan view, and FIG. 8B is a front view. FIGS. 9A and 9B show the box body; FIG. 9A is a back view, and FIG. 9B is a left side view. FIG. 10 is a bottom view of the box body.

As is shown in FIGS. 2 and 5 through 10, the box body 10 is formed in a substantially rectangular parallelepiped shape, and has a plurality of circuit unit accommodating parts 11 (four accommodating parts in the present embodiment) into which the circuit units 60 are inserted. The circuit unit accommodating parts 11 are provided such that there are two on the upper side and two on the lower side, with an upper-lower partition wall 12a in between. Furthermore, the two upper circuit unit accommodating parts 11 and the two lower circuit unit accommodating parts 11 are respectively divided into left and right, with partition walls 12b in between. The respective circuit unit accommodating parts 11 pass through the box body 10 in the front-back direction (with the left side in FIG. 2 being referred to as the front side, and the right side being referred to as the rear side). Moreover, as is shown in FIG. 7, a pair of locking tongue parts 13 that extend forward from the bottom wall of the box body 10 are provided in the rear portion of each of the two lower circuit unit accommodating parts 11, and a first opening 13a is formed in each of these locking tongue parts 13. In addition, second openings 13b are formed in the upper-lower partition wall 12a of the box body 10 in positions corresponding to the first openings 13a in the vertical direction. Locking projections 46 formed on the upper wall of the cover part 40 of the corresponding receptacle electrical connector 30 (described later) respectively enter the first openings 13a, and locking projections formed on the lower wall of the cover part 40 respectively enter the second openings 13b, so that the cover part 40 of the receptacle electrical connector 30 is locked with the box body 10. Meanwhile, as is shown in FIG. 6, a pair of locking tongue parts 14 that extend forward from the top wall of the box body 10 are provided in the rear portion of each of the two upper circuit unit accommodating parts 11, and a third opening 14a is formed in each of these locking tongue parts 14. Furthermore, fourth openings 14b are formed in the upper-lower partition wall 12a of the box body 10 in positions corresponding to the third openings 14a in the vertical direction. Locking projections 46 formed on the upper wall of the cover part 40 of the corresponding receptacle electrical connector 30 respectively enter the third openings 14a, and locking projections formed on the lower wall of the cover part 40 respectively enter the fourth openings 14b, so that the cover part 40 of the receptacle electrical connector 30 is locked with the box body 10.

Moreover, a first spring part 15a is provided on the right side wall (right side wall in FIG. 8A) of each of the circuit unit accommodating parts 11 of the box body 10, with this first spring part 15a driving the corresponding circuit unit 60 forward (downward in FIG. 18) and leftward (leftward in FIG. 18) as a result of the inclined surface 63a of the first rib 63 of the circuit unit 60 engaging with this first spring part 15a when the circuit unit 60 is inserted into the second position shown in FIG. 18 (described later). In addition, a second spring part 15b is provided on the left side wall of each of the circuit unit accommodating parts 11 of the box body 10, with this second spring part 15b driving the corresponding circuit unit 60 forward and rightward as a result of the inclined surface 65a of the third rib 65 of the circuit unit 60 engaging with this second spring part 15b when the circuit unit 60 is inserted into the second position. Furthermore, a locking part 16 is provided on the right side wall of each of the circuit unit accommodating parts 11 of the box body 10, with this locking part 16 restricting the forward movement of the corresponding circuit unit 60 by locking the perpendicular surface 64a of the second rib 64 of the circuit unit 60 when the circuit unit 60 is inserted into the second position. The "holding means" referred to in Claim 1 are constituted from the first spring parts 15a, second spring parts 15b, and locking parts 16 that are provided means when the circuit units 60 are inserted into the second position. Moreover, as is shown in FIG. 8A, first window parts 19a that allow the viewing of the corresponding first spring parts 15a and therefore allow the viewing of the state of engagement of these first spring parts 15a with the first ribs 63 of the corresponding circuit units 60 are formed in the upper wall of the box body 10. Likewise, as is shown in FIG. 8A, second window parts 19b that allow the viewing of the corresponding second spring parts 15b and therefore allow the viewing of the state of engagement of these second spring parts 15b with the third ribs 65 of the corresponding circuit units 60 are formed in the upper wall of the box body 10. Meanwhile, as is shown in FIG. 10, first window parts 19a that allow the viewing of the state of engagement of the corresponding first spring parts 15a with the first ribs 63 of the corresponding circuit units 60 are formed in the lower wall of the box body 10 as well. Likewise, second window parts 19b that allow the viewing of the state of engagement of the corresponding second spring parts 15b with the third ribs 65 of the corresponding circuit units 60 are formed in the lower wall of the box body 10 as well.

Furthermore, a reverse insertion preventing groove 17 that extends in the front-back direction is formed in the left side wall of each of the circuit unit accommodating parts 11 of the box body 10. In the insertion of the circuit units 60 into the respective circuit unit accommodating parts 11, when the circuit units 60 are inserted properly, the third ribs 65 provided on the circuit units 60 are respectively guided inside the reverse insertion preventing groove 17. On the other hand, if the circuit units 60 are inserted into the respective circuit unit accommodating parts 11upside down, the third ribs 65 bump into the right side walls of the respective circuit unit accommodating parts 11, so that the insertion is prevented. Moreover, the upper-lower partition wall 12a of the box body 10 is provided with a plurality of first spring parts 20a that eliminate wobbling of the circuit units 60 inserted into the upper circuit unit accommodating parts 11 by driving these circuit units 60 in the upward direction and a plurality of second spring parts 20b that eliminate wobbling of the circuit units 60 inserted into the lower circuit unit accommodating parts 11 by driving these circuit units 60 in the downward direction. In addition, attachment parts 18 for a vehicle body (not shown in the figures) are respectively provided at the front end of the right side wall and at the rear end of the left side wall of the box body 10. Note that FIG. 4C shows a circuit unit with the third rib 65 thereof being positioned at the center height of this circuit unit 60 in the vertical direction, and that FIG. 8B shows the circuit unit accommodating parts 11 with the reverse insertion preventing grooves 17 thereof being positioned at the center height of the corresponding circuit unit accommodating parts 11 in the vertical direction, but it would also be possible to provide the third ribs 65 at mutually different height positions by varying the heights of the third ribs 65 of the circuit units 60 inserted into the respective circuit unit accommodating parts 11 and to provide the reverse insertion preventing grooves 17 at mutually different height positions among the circuit unit accommodating parts 11 corresponding to the height positions of the third ribs 65. In so doing, specific circuit units 60 can be inserted into specific circuit unit accommodating parts 11, so that erroneous attachment of the circuit units 60 can be prevented.

Next, FIG. 11 is a plan view for illustrating the procedure for attaching receptacle electrical connectors to the box body. FIG. 12 is a perspective view as seen from the back side of the circuit unit accommodation box in which the receptacle electrical connectors have been attached to the box body. FIG. 13 is a back view of the circuit unit accommodation box in which the receptacle electrical connectors have been attached to the box body. FIG. 14 is a sectional view of the circuit unit accommodation box in which the receptacle electrical connectors have been attached to the box body. FIG. 15 is a sectional view showing a state prior to the insertion of the circuit units into the circuit unit accommodation box; in this FIG. 15, however, a circuit unit has been inserted into the left-side circuit unit accommodating part out of the upper circuit unit accommodating parts. FIG. 16 is a sectional view of essential parts showing a state prior to the insertion of the circuit units into the circuit unit accommodation box, with the position of the cross section being varied from FIG. 15. FIG. 17 is a sectional view showing a state in which a circuit unit has been inserted into the first position, and the first connector of the circuit unit has mated with the corresponding second connector. FIG. 18 is a sectional view showing a state in which the circuit unit has been inserted into the second position, and the accommodation of the circuit unit in the circuit unit accommodation box has been completed.

The receptacle electrical connectors 30 shown in FIGS. 11 through 14 each comprise a cover part 40 that receives the corresponding circuit unit 60 comprising a first connector 71 and that guides this circuit unit 60 to a specified position, and a second connector 50 that is accommodated inside the cover part 40 and that mates with the first connector 71. Here, the "specified position" is a position into which the circuit unit 60 is ultimately inserted (equivalent to the second position) and a position from which the circuit unit 60 cannot be inserted any further.

The cover part 40 has a substantially flattened square cylindrical shape, and is designed to receive the housing 61 of the corresponding circuit unit 60 in the front portion (lower portion in FIG. 11) and to receive the housing 72 of the first connector 71 in the rear portion. Moreover, as is shown in FIGS. 14 and 16, a connector accommodating part 41 that accommodates the second connector 50 is formed in the rear portion of the cover part 40. A through-hole 41a that extends through the accommodating part 41 in the front-back direction and that accommodates the second connector 50 is formed in the interior of the connector accommodating part 41. Furthermore, a pair of latch arms 42 is provided with one latch arm being provided on either side wall of the connector accommodating part 41 in the direction of width. The respective latch arms 42 are formed in a cantilever shape that extends forward from the rear portion of either side wall of the connector accommodating part 41 in the direction of width such that the vicinity of the tip ends of these latch arms 42 protrude into the through-hole 41a. Moreover, first projections (locking means) 43 for locking the second connector 50 inside the connector accommodating part 41 are respectively formed at the tip ends of these latch arms 42 in the central portions in the vertical direction such that these first projections 43 protrude into the through-hole 41a, and pairs of second unlocking projections (unlocking means) 44 for unlocking the second connector 50 from the first projections 43 are respectively formed at the tip ends of the latch arms 42 at two ends in the vertical direction (one pair at the upper end and the other pair at the lower end) such that these second unlocking projections 44 protrude into the through-hole 41a. In addition, a pair of cantilever-form supporting arms 45 that extend from the vicinity of the rear end portion of the connector accommodating part 41 to the vicinity of the front end portion is provided with one supporting arm being provided on the upper wall and the other supporting arm being provided on the lower wall of the cover part 40. Furthermore, as is shown in FIG. 11, locking projections 46 for locking the cover part 40 in the box body 10 by entering the corresponding first openings 13a or third openings 14a of the box body 10 are provided on the upper wall of the cover part 40. Likewise, locking projections (not shown in the figures) for locking the cover part 40 in the box body 10 by entering the corresponding second openings 13b or fourth openings 14b of the box body 10 are provided on the lower wall of the cover part 40.

Moreover, each second connector 50 comprises a substantially rectangular housing 51 and contacts (not shown in the figures) that are attached to the housing 51 in a plurality of rows and that make contact with the contacts of the corresponding first connector 71 in the front portions thereof. The respective contacts of the second connector 50 are connected to electrical wires (not shown in the figures) in the rear portions thereof. As is shown in FIGS. 14 and 16, a pair of second projections 52 that are locked with the first projections 43 provided on the connector accommodating part 41 are formed with one second projection 52 being formed on either end surface in the direction of width of the housing 51 of the second connector 50. Furthermore, pairs of projecting ribs 53 (see FIG. 11) that extend in the front-back direction are respectively formed so as to protrude from two surfaces (one pair from the upper surface and the other pair from the lower surface) of the housing 51 of the second connector 50. Moreover, pairs of locking projections 54 that respectively enter the openings 75a of the locking parts 75 of the corresponding first connector 71 and lock the first connector 71 and second connector 50 are formed so as to protrude from the vicinity of the front end portions of two surfaces (one pair from the upper surface and the other pair from the lower surface) of the housing 51 of the second connector 50. In addition, an erroneous mating prevention hole (not shown in the figures) into which the erroneous mating prevention plate 77 provided on the first connector 71 is fitted is bored substantially in the central portion in the direction of width of the front surface of the housing 51 of the second connector 50 slightly toward the upper side in the vertical direction.

Next, the procedure for attaching the receptacle electrical connectors 30 to the box body 10 will be described. First, each of the second connectors 50 attached to the end of a wire harness (electrical wires) is accommodated inside the through-hole 41a of the connector accommodating part 41 of the cover part 40 from the rear side of the cover part 40 as indicated by arrow (1) in FIG. 11. Consequently, the second projections 52 of the second connector 50 respectively ride over the first projections 43, and are positioned forward from these first projections 43, so that the rearward movement is restricted. When the second projections 52 ride over the first projections 43 in this manner, the front end surface of the housing 51 of the second connector 50 is located in a position that substantially coincides with the front end surface of the connector accommodating part 41 of the corresponding cover part 40. Then, the front end surfaces of the pairs of projecting ribs 53 provided on two surfaces (one pair on the upper surface and the other pair on the lower surface) of the housing 51 of the second connector 50 contact the rear end surfaces of stopper projections (not shown in the figures) provided on the connector accommodating part 41, so that the forward movement of the second connector 50 is restricted. As a result, a receptacle electrical connector 30 is completed.

Furthermore, the plurality of electrical connectors 30 (four connectors in the present embodiment) are respectively accommodated inside the circuit unit accommodating parts 11 from the rear side of the box body 10 as indicated by arrow (2) in FIG. 11. Consequently, with regard to the electrical connectors 30 accommodated in the upper circuit unit accommodating parts 11, the locking projections 46 formed on the upper walls of the cover parts 40 respectively enter the third openings 14a of the locking tongue parts 14 of the box body 10, and the locking projections formed on the lower walls of the cover parts 40 respectively enter the fourth openings 14b of the locking tongue parts 14 of the box body 10, so that these electrical connectors 30 are fastened to the box body 10. Likewise, with regard to the electrical connectors 30 accommodated in the lower circuit unit accommodating parts 11, the locking projections 46 formed on the upper walls of the cover parts 40 respectively enter the first openings 13a of the locking tongue parts 13 of the box body 10, and the locking projections formed on the lower walls of the cover parts 40 respectively enter the second openings 13b of the locking tongue parts 13 of the box body 10, so that these electrical connectors 30 are fastened to the box body 10. As a result, the circuit unit accommodation box 1 is completed as shown in FIGS. 12 through 14.

Next, a method for accommodating the circuit units 60 in the circuit unit accommodation box 1 will be described with reference to FIGS. 15 through 18.

First, in the state shown in FIG. 15 in which the individual circuit units 60 are not accommodated in the circuit unit accommodation box 1, the respective circuit units 60 are caused to advance from the front side of the box body 10 in the direction indicated by arrow A in FIGS. 15 and 16 (opposite direction from the direction of attachment of the second connectors 50 inside the cover parts 40). Then, the circuit units 60 are respectively inserted into the circuit unit accommodating parts 11 of the box body 10 to the first position shown in FIG. 17. In this case, if the circuit units 60 are inserted in the proper vertical direction, the third ribs 65 provided on the circuit units 60 are respectively guided inside the reverse insertion preventing grooves 17. In contrast, if the circuit units 60 are inserted into the respective circuit unit accommodating parts 11upside down, then the third ribs 65 bump into the right side walls of the respective circuit unit accommodating parts 11, so that the insertion is prevented.

When the circuit units 60 are inserted into the circuit unit accommodating parts 11 to the first position shown in FIG. 17, the first connectors 71 respectively mate with the second connectors 50, so that the contacts of the first connectors 71 and the contacts of the second connectors 50 make electrical contact with each other. In this state, furthermore, the locking parts 75 of the first connectors 71 respectively ride over the locking projections 54 of the second connectors 50, and the locking projections 54 respectively enter the openings 75a, thus completing the locking of the first connectors 71 and the second connectors 50. Note that in this state, the first unlocking projections 76 provided on the first connectors 71 respectively contact the second unlocking projections 44 provided on the latch arms 42 of the cover parts 40.

Then, when the respective circuit units 60 are caused to advance further, a state is created in which the circuit units 60 are inserted from the first position to a position that is further toward the interior. In this case, the first unlocking projections 76 provided on both sides in the direction of width of the first connectors 71 respectively push the latch arms 42 provided on both sides in the direction of width of the cover parts 40 outward via the second unlocking projections 44 of these latch arms 42. As a result, the unlocking of the second connectors 50 from the first projections 43 is initiated. Note that in this state, the locking parts 75 of the first connectors 71 have respectively ridden over the locking projections 54 of the second connectors 50, and the locking projections 54 have respectively entered the openings 75a, so that the locked state of the first connectors 71 and second connectors 50 is maintained.

When the circuit units 60 are caused to advance further, the first unlocking projections 76 provided on both sides in the direction of width of the first connectors 71 respectively ride over the second unlocking projections 44 of the latch arms 42 provided on both sides in the direction of width of the cover parts 40, and these latch arms 42 return to the original positions. Then, the second projections 52 on both sides in the direction of width of the second connectors 50 respectively move rearward together with the second connectors 50, and are positioned on the rear side of the first projection 43 provided on the latch arms 42 on both sides in the direction of width of the cover parts 40. As a result, the unlocking the second connectors 50 from the first projections 43 is completed. When the unlocking the second connectors 50 from the first projections 43 is completed, the second connectors 50 can respectively slide inside the connector accommodating parts 41 in the direction of insertion and withdrawal of the circuit units 60.

Then, when the respective circuit units 60 are caused to advance further, a state is created in which the circuit units 60 have been inserted into the specified final position, i.e., the second position, as shown in FIG. 18. In this state, the inclined surface 63a of the first rib 63 provided on the right side wall of each circuit unit 60 engages with the first spring part 15a provided on the right side wall of the corresponding circuit unit accommodating part 11 of the box body 10, so that the circuit unit 60 is driven toward the front and toward the left. Likewise, as is shown in FIG. 18, the inclined surface 65a of the third rib 65 provided on the left side wall of each circuit unit 60 engages with the second spring part 15b provided on the left side wall of the corresponding circuit unit accommodating part 11 of the box body 10, so that the circuit unit 60 is driven toward the front and toward the right. Furthermore, the locking part 16 provided on the right side wall of each circuit unit accommodating part 11 of the box body 10 is locked with the perpendicular surface 64a of the second rib 64 provided on the right side wall of the corresponding circuit unit 60, so that the forward movement of the circuit unit 60 is restricted. As a result, the circuit unit 60 is held in the box body 10. Here, the circuit unit 60 is driven in the leftward direction by the first spring part 15a and driven in the rightward direction by the second spring part 15b, so that it is possible to prevent wobbling in the left-right direction (direction of width) of the circuit unit 60 with respect to the box body 10. Moreover, the circuit unit 60 is driven toward the front by the first spring part 15a and second spring part 15b, and the forward movement is restricted by the locking part 16, so that it is possible to prevent wobbling in the front-back direction of the circuit unit 60 as well with respect to the box body 10.

Moreover, in the circuit unit accommodation box 1 of the present embodiment, when the circuit units 60 comprising the first connectors 71 are respectively inserted into the circuit unit accommodating parts 11 of the box body 10 to the first position, the first connectors 71 mate with the second connectors 50 of the corresponding receptacle electrical connectors 30, so that the first connectors 71 and the second connectors 50 are electrically connected. Then, when the circuit units 60 are inserted into the second position, the circuit units 60 are held in the box body 10 by the holding means composed of the first spring parts 15a, second spring parts 15b, and locking parts 16 that are provided on the box body 10 and the first ribs 63, third ribs 65, and second ribs 64 that are provided on the circuit units 60. Therefore, it is possible to provide a circuit unit accommodation box 1 that can reliably accommodate the circuit units 60 comprising the first connectors 71.

In addition, the circuit units 60 can be attached to the circuit unit accommodation box 1 merely by inserting these circuit units 60 into the box body 10, so that it is possible to attach the circuit units 60 to the circuit unit accommodation box 1 with a simple operation and also to electrically connect the first connectors 71 of the circuit units 60 and the second connectors 50 on the side of a vehicle body.

Furthermore, the first position in which the first connectors 71 and the second connectors 50 mate with each other is different from the second position in which the circuit units 60 are held in the box body 10, and the peak A of the force required for the mating of the connectors and the peak B of the force required for the locking for the purpose of holding the circuit units 60 in the box body 10 are separated from each other. Therefore, the worker can easily perceive by sensation that the attachment of the circuit units 60 to the circuit unit accommodation box 1 is completed.

Moreover, because the peak A and peak B of the forces described above are separated, the peak value (maximum value) of each of the forces is smaller than that in a case in which these peaks overlap, so that workability is favorable.

Meanwhile, it would also be possible to produce sensation as if the force had only one peak by respectively adjusting the first position and second position as well as the maximum values of the peak A and peak B of the forces. In this case, attachment is completed simply by pushing the circuit units 60 into the circuit unit accommodation box 1 against a single peak in the force, so that there is no need for the worker to confirm that the peak B of the force is perceived following the peak A of the force. Therefore, failure in the mating of the circuit units 60 with the circuit unit accommodation box 1 is more easily prevented.

In addition, the first window parts 19a that allow the viewing of the state of engagement of the first spring parts 15a with the first ribs 63 of the corresponding circuit units 60 are formed in the upper wall and lower wall of the box body 10. Likewise, the second window parts 19b that allow the viewing of the state of engagement of the second spring parts 15b with the third ribs 65 of the corresponding circuit units 60 are formed in the upper wall and lower wall of the box body 10. Therefore, depending on the mounted state of the circuit unit accommodation box 1, it is possible to view the state of the circuit units 60 being held in the second position from the first window parts 19a and second window parts 19b and also to confirm that the circuit units 60 are firmly mounted to the circuit unit accommodation box 1.

Furthermore, because the box body 10 comprises the attachment parts 18 for a vehicle body, the circuit unit accommodation box 1 can be attached to the vehicle body. Moreover, because the second connectors 50 are respectively attached inside the cover parts 40 from the direction opposite to the circuit unit insertion direction (i.e., the direction indicated by arrow A in FIGS. 15 and 16), the second connectors 50 at the wire harness end can be combined with the box body 10 before the circuit units 60 are respectively assembled to the circuit unit accommodation box 1 when the circuit unit accommodation box 1 is to be attached to the vehicle body. As a result, man-hours in the assembly work of the circuit units 60 can be reduced, and half-mating of the first connectors 71 with the second connectors 50 can be prevented.

An embodiment of the present invention has been described above. However, the present invention is not limited to this embodiment, and various alterations and modifications can be made.

For example, it is sufficient if the holding means for holding the circuit units 60 in the box body 10 hold the circuit units 60 in the box body 10 when these circuit units 60 are inserted from the first position to the second position; it is not absolutely necessary to construct the holding means from the first spring parts 15a, second spring parts 15b, and locking parts 16 that are respectively provided on the box body 10 and the first ribs 63, third ribs 65, and second ribs 64 that are respectively provided on the circuit units 60.

Furthermore, the box body 10 has four circuit unit accommodating parts 11 in the present embodiment, but there may be any number of circuit unit accommodating parts 11 as long as the number is one or more.

## Claims

1. A circuit unit accommodation box (1) comprising
a box body (10) having at least one circuit unit accommodating part (11) into which a circuit unit (60) such as an ECU, which is equipped with a first connector (71), is inserted, and
a receptacle electrical connector (30) that is disposed in the circuit unit accommodating part (11) and that makes an electrical connection with the inserted circuit unit (60), the receptacle electrical connector (30) comprising:
a cover part (40) that receives the circuit unit (60) and guides the circuit unit (60) to a specified position, the cover part (40) comprising locking projections (46) that are provided on an upper wall and a lower wall of the cover part (40), the locking projections (46) being configured to enter corresponding openings (13a, 13b, 14a, 14b) of the box body (10) for locking the cover part (40) to the box body (10);
a second connector (50) that is accommodated inside the cover part (40) and locked with the cover part (40) by locking means (43) and that mates with the first connector (71) and establishes electrical connection with the first connector (71) when the received circuit unit (60) is inserted into a first position, and unlocking means (44) for unlocking the second connector (50) from the locking means (43) when the circuit unit (60) is inserted from the first position into a position further toward the interior, with the second connector (50) becoming slidable inside the cover part (40) in the direction of insertion and withdrawal of the circuit unit (60) after the second connector (50) is unlocked by the unlocking means (44), and wherein
the box body (10) and the circuit unit (60) comprise holding means for holding the circuit unit (60) in the box body (10) when the circuit unit (60) is inserted from the first position to a second position via the interior position, the holding means comprising:
first, second and third vertically extending ribs (63, 64, 65) provided on side surfaces of the circuit unit (60), the first and third ribs (63, 65) having inclined surfaces (63a, 65a) on respective front sides and the second rib (64) having a perpendicular surface (64a) on the rear side;
spring parts (15a, 15b) provided on the right and left sides of the circuit unit accommodating part (11), wherein the spring parts (15a, 15b) are configured to engage the inclined surfaces (63a, 65a) of the first and third ribs (63, 65) in order to drive the circuit unit (60) in a direction opposite to the direction of insertion;
a locking part (16) on the wall of the circuit unit accommodating part (11), the locking part (16) being configured to restrict the movement in the direction opposite to the direction of insertion by locking the perpendicular surface (64a) of the second rib (64) in order to prevent wobbling.

2. The circuit unit accommodation box (1) according to Claim 1, wherein the box body (10) is provided with a window part (19a, 19b) that allows the viewing of the state of the circuit unit (60) being held by the holding means.

3. The circuit unit accommodation box (1) according to Claim 1 or 2, wherein the box body (10) comprises an attachment part for a vehicle body, and the second connector (50) is attachable inside the cover part (40) from the direction opposite of the circuit unit insertion direction.

## Patentansprüche

1. Aufnahmebox (1) für eine Schaltungseinheit, aufweisend:
einen Kastenkörper (10) mit mindestens einem Schaltungseinheit-Aufnahmeteil (11), in das eine mit einem ersten Verbinder (71) ausgestattete Schaltungseinheit (60), wie z.B. eine ECU, eingesetzt wird, und
einen buchsenartigen elektrischen Verbinder (30), der in dem Schaltungseinheit-Aufnahmeteil (11) angeordnet wird und eine elektrische Verbindung mit der eingesetzten Schaltungseinheit (60) herstellt, wobei der buchsenartige elektrische Verbinder (30) aufweist:
ein Abdeckungsteil (40), das die Schaltungseinheit (60) aufnimmt und die Schaltungseinheit (60) in eine bestimmte Position führt, wobei das Abdeckungsteil (40) Verriegelungsvorsprünge (46) aufweist, die an einer oberen Wand und einer unteren Wand des Abdeckungsteils (40) vorgesehen sind, wobei die Verriegelungsvorsprünge (46) dazu ausgebildet sind, in entsprechende Öffnungen (13a, 13b, 14a, 14b) des Kastenkörpers (10) einzutreten, um das Abdeckungsteil (40) an dem Kastenkörper (10) zu verriegeln;
einen zweiten Verbinder (50), der im Inneren des Abdeckungsteils (40) aufgenommen wird und an dem Abdeckungsteil (40) durch eine Verriegelungseinrichtung (43) verriegelt wird und der mit dem ersten Verbinder (71) in Verbindung tritt und eine elektrische Verbindung mit dem ersten Verbinder (71) herstellt, wenn die aufgenommene Schaltungseinheit (60) in eine erste Position eingesetzt wird, und eine Entriegelungseinrichtung (44) zum Entriegeln des zweiten Verbinders (50) von der Verriegelungseinrichtung (43) aufweist, wenn die Schaltungseinheit (60) von der ersten Position in eine weiter innen befindliche Position eingesetzt wird, wobei der zweite Verbinder (50) innerhalb des Abdeckungsteils (40) in Richtung des Einführens und Herausziehens der Schaltungseinheit (60) verschiebbar wird, nachdem der zweite Verbinder (50) durch die Entriegelungseinrichtung (44) entriegelt wird, und
wobei der Kastenkörper (10) und die Schaltungseinheit (60) eine Halteeinrichtung zum Halten der Schaltungseinheit (60) in dem Kastenkörper (10) aufweisen, wenn die Schaltungseinheit (60) von der ersten Position über die innere Position in eine zweite Position eingesetzt wird; wobei die Halteeinrichtung aufweist:
eine erste, zweite und dritte vertikal verlaufende Rippe (63, 64, 65), die an Seitenflächen der Schaltungseinheit (60) vorgesehen sind, wobei die erste und die dritte Rippe (63, 65) geneigte Oberflächen (63a, 65a) an jeweiligen Vorderseiten aufweisen und die zweite Rippe (64) eine senkrechte Oberfläche (64a) an der Rückseite aufweist;
Federteile (15a, 15b), die auf der rechten und der linken Seite des Schaltungseinheit-Aufnahmeteils (11) vorgesehen sind, wobei die Federteile (15a, 15b) dazu ausgebildet sind, mit den geneigten Oberflächen (63a, 65a) der ersten und der dritten Rippe (64, 65) zusammenzuwirken, damit die Schaltungseinheit (60) in einer der Einführrichtung entgegengesetzten Richtung antriebsmäßig bewegt wird;
ein Verriegelungsteil (16) an der Wand des Schaltungseinheit-Aufnahmeteils (11), wobei das Verriegelungsteil (16) dazu ausgebildet ist, die Bewegung in der zu der Einführrichtung entgegengesetzten Richtung durch Verriegeln der senkrechten Oberfläche (64a) der zweiten Rippe (64) zu unterbinden, um Wackeln zu verhindern.

2. Aufnahmebox (1) für eine Schaltungseinheit nach Anspruch 1,
wobei der Kastenkörper (10) mit einem Fensterbereich (19a, 19b) versehen ist, der das Betrachten des Zustands der von der Halteeinrichtung gehaltenen Schaltungseinheit (60) ermöglicht.

3. Aufnahmebox (1) für eine Schaltungseinheit nach Anspruch 1 oder 2,
wobei der Kastenkörper (10) ein Befestigungsteil für eine Fahrzeugkarosserie aufweist und der zweite Verbinder (50) aus der zur Schaltungseinheit-Einführrichtung entgegengesetzten Richtung innerhalb des Abdeckungsteils (40) anbringbar ist.

## Revendications

1. Boîtier pour le logement d'un circuit (1) comprenant
un corps de boîtier (10) ayant au moins une portion de logement de circuit (11) dans laquelle un circuit (60), telle une unité de commande électrique ECU équipée d'un premier connecteur (71), est inséré, et
un connecteur électrique de réception (30) qui est disposé dans la portion de logement de circuit (11) et qui établit une connexion électrique avec le circuit inséré (60), le connecteur électrique de réception (30) comprenant:
une pièce de couverture (40) qui reçoit le circuit (60) et guide le circuit (60) dans une position spécifique, la pièce de couverture (40) comprenant des saillies de verrouillage (46) qui sont agencées sur une paroi supérieure et une paroi inférieure de la pièce de couvercle (40), les saillies de verrouillage (46) étant configurées pour pénétrer dans des ouvertures correspondantes (13a, 13b, 14a, 14b) du corps de boîtier (10) pour verrouiller la pièce de couverture (40) au corps de boîtier (10) ;
un second connecteur (50) qui est logé à l'intérieur de la pièce de couverture (40) et est verrouillé à la pièce de couverture (40) par des moyens de verrouillage (43) et qui correspond au premier connecteur (71) et établit une connexion électrique avec le premier connecteur (71) lorsque le circuit (60) est logé et inséré dans une première position, et des moyens de déverrouillage (44) pour déverrouiller le second connecteur (50) des moyens de verrouillage (43) lorsque le circuit (60) est inséré depuis la première position vers une position plus avancée vers l'intérieur, le second connecteur (50) devenant coulissable à l'intérieur de la pièce de couverture (40) dans la direction d'insertion et de retrait du circuit (60) après le déverrouillage du second connecteur (50) par les moyens de déverrouillage (44),
le corps de boîtier (10) et le circuit (60) comprenant des moyens de maintien pour maintenir le circuit (60) dans le corps de boîtier (10) lorsque le circuit est inséré depuis la première position vers une seconde position via la position intérieure, les moyens de maintien comprenant:
des première, deuxième et troisième nervures (63, 64, 65) s'étendant verticalement depuis des surfaces latérales du circuit (60), les première et troisième nervures (63, 65) ayant des surfaces inclinées (63a, 65a) à l'avant des faces respectives, et la seconde nervure (64), à l'arrière, ayant une surface perpendiculaire (64a);
des éléments faisant office de ressort (15a, 15b) prévus sur les côtés droit et gauche de la portion de logement de circuit (11), les éléments faisant office de ressort (15a, 15b) étant configurés pour coopérer avec les surfaces inclinées (63a, 65a) des première et troisième nervures (63, 65) afin d'entraîner le circuit (60) dans une direction opposée à la direction d'insertion;
un élément de verrouillage (16) sur la paroi de la portion de logement du circuit (11), l'élément de verrouillage (16) étant configuré pour restreindre le mouvement dans la direction opposée à la direction d'insertion en verrouillant la surface perpendiculaire (64a) de la deuxième nervure (64) afin d'éviter les vibrations.

2. Boîtier de logement de circuit (1) selon la revendication 1, dans lequel le corps de boîtier (10) est pourvu d'une fenêtre (19a, 19b) qui permet de voir l'état du circuit (60) alors qu'il est maintenu par les moyens de maintien.

3. Boîtier de logement de circuit (1) selon la revendication 1 ou 2, dans lequel le corps de boîtier (10) comprend une partie de fixation à une carrosserie de véhicule, et le second connecteur (50) peut être fixé à l'intérieur de la pièce de couverture (40) depuis la direction opposée à la direction d'insertion du circuit.
